Europäisches Patentamt

European Patent Office

Office européen des brevets

(11) Publication number: **0 467 096 A1**

## EUROPEAN PATENT APPLICATION

(21) Application number: **91110301.8**

(22) Date of filing: **22.06.91**

(51) Int. Cl.⁵: **B29C 71/04**, B29C 59/10, B29D 9/00, B32B 27/16, B32B 27/32, //B29K79:00, B29K27:18,B29L9:00

(30) Priority: **28.06.90 US 545043**

(43) Date of publication of application:
**22.01.92 Bulletin 92/04**

(84) Designated Contracting States:
**DE FR GB IT LU NL**

(71) Applicant: **E.I. DU PONT DE NEMOURS AND COMPANY**
**1007 Market Street**
**Wilmington Delaware 19898(US)**

(72) Inventor: **Katz, Morton**
**2245 Lane Road**
**Columbus, Ohio 43220(US)**
Inventor: **Schmidt, Francis Henry**
**1632 Chippewa Court**
**Grove City, Ohio 43123(US)**

(74) Representative: **von Kreisler, Alek,**
**Dipl.-Chem. et al**
**Patentanwälte Von Kreisler-Selting-Werner,**
**Deichmannhaus am Hauptbahnhof**
**W-5000 Köln 1(DE)**

(54) Process for preparing laminate of a polyimide and a fluorocarbon polymer.

(57) A laminar structure of a polyimide and a fluorocarbon polymer having superior adhesion is prepared by treating the contacting surface of the polyimide with an electric discharge and treating the contacting surface of the fluorocarbon polymer with an electric discharge in an acetone atmosphere. The structure is heat-sealable and suitable for use as an electrical insulation.

## BACKGROUND OF THE INVENTION

The present invention relates to a process for preparing a laminar structure of a polyimide and a fluorocarbon polymer having improved adhesion properties.

Laminar structures of polyimide polymeric materials and fluorocarbon polymers are well-known articles of manufacture having a unique combination of physical properties making them useful as a substrate for an electric or electronic device or as an insulating film.

Numerous processes have evolved for preparing laminar structures of a polyimide and a fluorocarbon polymer such as, for example, disclosed in U.S. 3,179,634 which describes a laminar structure of a polyimide and a fluorocarbon polymer prepared by treating the surface of the fluorocarbon polymer with an electrical discharge in ambient air to improve surface adherability, coating the treated polymer with a polyamide-acid precursor of the desired polyimide and converting the polyamide-acid to polyimide.

U.S. 3,627,624 discloses a process for preparing a laminar article of a polyimide and a fluorocarbon polymer having improved adhesion by electrical discharge treatment of the fluorocarbon polymer in an atmosphere containing acetone. The structure is heat-sealable and suitable for electrical insulation uses.

U.S. 4,801,506 also discloses a laminar structure of a polyimide and a fluorocarbon polymer prepared by electrical discharge treatment of both contacting surfaces of the polyimide and the fluorocarbon polymer. Both the polyimide and the fluorocarbon polymer are discharge treated in ambient air atmosphere and there is no suggestion of the criticality of treating the fluorocarbon polymer in an acetone atmosphere.

It has now been found that laminar structures of a polyimide and a fluorocarbon polymer having much superior adhesion to those of the prior art can be prepared by treating the contacting surface of the polyimide with an electrical discharge and treating the contacting surface of the fluorocarbon polymer with an electrical discharge in an acetone atmosphere.

## SUMMARY OF THE INVENTION

According to the present invention there is provided a process for preparing a laminar structure comprising at least one layer of a polyimide that has been treated with an electrical discharge and at least one layer of a fluorocarbon polymeric material that has been treated with an electrical discharge in an atmosphere of acetone.

More specifically, there is provided a process for preparing a laminar structure comprising at least one layer of a polyimide treated with an electrical discharge and at least one layer of a copolymer of hexafluoropropylene and tetrafluoroethylene treated with an electrical discharge in an atmosphere of acetone.

## FIGURE

The figure portrays various layer constructions employed in the examples.

## DETAILED DESCRIPTION OF THE INVENTION

According to the present invention there is provided a process for preparing a laminar structure of a polyimide and a fluorocarbon polymer comprising laminating a base layer of a polyimide film that has been subjected to electrical discharge treatment to a film of a fluorocarbon polymer that has been subjected to electrical discharge treatment in an acetone atmosphere preferably a nitrogen/acetone atmosphere at room temperature and atmospheric pressure. At treating speeds of 40 to 80 feet per minute a typical exposure electrical discharge as a corona is about 0.0625 to 0.125 seconds.

The laminar structure is characterized by having at least one layer of a polyimide prepared by reacting an aromatic tetracarboxylic acid dianhydride with a diamine in an inert organic solvent to form a polyamide-acid solution and subsequently converting the polyamide-acid to polyimide essentially as described in U.S. 3,179,614; U.S. 3,179,630 and U.S. 3,179,634 which are incorporated herein by reference.

Suitable diamines for use in the polyimides of the invention include:
meta-phenylene diamine;
paraphenylene diamine;
4,4'-diamino-diphenyl propane;
4,4'-diamino-diphenyl methane;
benzidine;
4,4'-diamino-diphenyl sulfide;

EP 0 467 096 A1

4,4'-diamino-diphenyl sulfone;
3,3'-diamino-diphenyl sulfone;
4,4'-diamino-diphenyl ether;
2,6-diamino-pyridine;
bis-(4-amino-phenyl)diethyl silane;
bis-(4-amino-phenyl)phosphine oxide;
bis-(4-amino-phenyl)-N-methylamine;
1,5-diamino-naphthalene;
3,3'-dimethyl-4,4'-diamino-biphenyl;
3,3'-dimethoxy benzidine;
2,4-bis(beta-amino-t-butyl)toluene;
bis-(para-beta-amino-t-butyl-phenyl)ether;
para-bis(2-methyl-4-amino-pentyl)benzene;
para-bis-(1,1-dimethyl-5-amino-pentyl)benzene;
m-xylylene diamine;
p-xylylene diamine;
bis(para-amino-cyclohexyl)methane;
hexamethylene diamine;
heptamethylene diamine;
octamethylene diamine;
nonamethylene diamine;
decamethylene diamine;
3-methylheptamethylene diamine;
4,4-dimethylheptamethylene diamine;
2,11-diamino-dodecane;
1,2-bis-(3-amino-propoxy)ethane;
2,2-dimethyl propylene diamine;
3-methoxy-hexamethylene diamine;
2,5-dimethylhexamethylene diamine;
2,5-dimethylheptamethylene diamine;
5-methylnonamethylene diamine;
1,4-diamino-cyclohexane;
1,12-diamino-octadecane;
$H_2N(CH_2)_3O(CH_2)_3NH_2$;
$H_2N(CH_2)_3S(CH_2)_3NH_2$;
$H_2N(CH_2)_3N(CH_3)(CH_2)_3NH_2'$
and mixtures thereof.

Useful solvents include normally liquid N,N-dialkylcarboxylamides, generally. Preferred solvents include the lower molecular weight members of such carboxylamides, particularly N,N-dimethylformamide and N,N-dimethylacetamide. Other useful compounds of this class of solvents are N,N-diethylformamide and N,N-diethylacetamide. Other solvents which may be used are dimethylsulfoxide, N-methyl-2-pyrrolidone, tetramethyl urea, dimethylsulfone, hexamethylphosphoramide, tetramethylene sulfone, and the like. The solvents can be used alone, in combinations with one another or in combinations with poor solvents such as benzene, benzonitrile, dioxane, etc. The amount of solvent used preferably ranges from 75 to 90 weight % of the polyamic acid, since this concentration has been found to give optimum molecular weight.

Conversion of the polyamic acid to polyimide can be accomplished by either a thermal conversion or a chemical conversion process. According to the thermal conversion process, the polyamic acid solution is cast on a heated conversion surface, such as a metal drum or belt, and heated at a temperature of above about 50°C to partially convert the polyamic acid to polyimide. The extent of polyamic acid conversion depends on the temperature employed and the time of exposure, but, generally about 25 to 95% of amic acid groups are converted to imide groups. The partially converted polyamic acid is then heated at or above 220°C to obtain complete conversion to the polyimide.

In the chemical conversion process, the polyamic acid solution is first chilled to about 10°C to -10°C and polyamic acid conversion chemicals are added. The polyamic acid conversion chemicals are tertiary amine catalysts and anhydride dehydrating materials. The preferred anhydride dehydrating material is acetic anhydride and is used in slight molar excess of the amount of amic acid groups in the polyamic acid, typically about 2-2.5 moles per equivalent of polyamic acid. A comparable amount of tertiary amine catalyst is used. Besides acetic anhydride, other operable lower fatty acid anhydrides include propionic, butyric,

3

valeric, mixed anhydrides of these with one another and with anhydrides of aromatic monocarboxylic acids, for example, benzoic acid, naphthoic acid, and the like, and with anhydrides of carbonic and formic acids, as well as aliphatic ketenes (ketene and dimethyl ketene). Ketenes may be regarded as anhydrides of carboxylic acids derived from drastic dehydration of the acids.

The preferred tertiary amine catalysts are pyridine and beta-picoline and they are used in an amount of about one mole per mole of anhydride dehydrating material. Tertiary amines having approximately the same activity as the preferred pyridine and beta-picoline may also be used. These include 3,4-lutidine; 3,5-lutidine; 4-methyl pyridine; 4-isopropyl pyridine; N-dimethyl benzyl amine; isoquinoline; 4-benzyl pyridine, and N-dimethyl dodecyl amine. Trimethyl amine and triethyl amine are more active than those amines listed above and can be used in smaller amounts.

The polyamic acid conversion chemicals react at about room temperature or above to convert polyamic acid to polyimide. The chemical conversion reaction occurs at temperatures from 10 to 120°C, with the reaction being very rapid at the higher temperatures and very slow at the lower temperatures. Below a certain temperature, polyamic acid chemical conversion comes to a practical halt. This temperature is generally about 10°C. It is important, therefore, that the polyamic acid solution be chilled below this temperature before adding the polyamic acid conversion chemicals and that the temperature of the solution, with conversion chemicals, be maintained below this temperature during extrusion or casting.

The treated, chilled, polyamic acid solution is cast or extruded onto a heated conversion surface whereupon some of the solvent is evaporated from the solution, the polyamic acid is partially chemically converted to polyimide, and the solution takes the form of a polyamic acid-polyimide gel. Conversion of amic acid groups to imide groups depends on contact time and temperature but is usually about 25 to 95% complete.

The gel is subsequently dried to remove the water, residual solvent, and remaining conversion chemicals, and the polyamic acid is completely converted to polyimide. The drying can be conducted at relatively mild conditions without complete conversion of polyamic acid to polyimide at that time, or the drying and conversion can be conducted at the same time using higher temperatures. Preferably, high temperatures are used for short times to dry the film and convert it to polyimide in the same step. It is preferred to heat the film to a temperature of 200-450°C for 15 to 400 seconds.

The fluorocarbon polymer film used in the invention can be a film of any fluorocarbon polymer. Examples include a copolymer of tetrafluoroethylene and hexafluoropropylene (FEP), a fluorinated alkoxyethylene copolymer (PFA), a fluorinated ethylenepropylene ether copolymer (EPE) and tetrafluoroethylene (TFE).

The fluorocarbon polymer film is preferably a copolymer of between about 50% by weight and about 95% by weight tetrafluoroethylene and between about 5% by weight and 50% by weight of hexafluoropropylene. A preferred fluorocarbon copolymer contains from about 7 to 27% by weight hexafluoropropylene. The thickness of the fluorocarbon polymer film ranges from 0.5 to 5.0 mils.

The electrical discharge treatment of a surface of the polyimide film is well-known in the art. For instance, corona discharge or plasma discharge is generated on a surface of the polyimide film. The conditions for the electric discharge treatment of the polyimide can be appropriately determined in consideration of the desired conditions of the film surface, physical properties of the film, and other requirements in known manner. For example, corona discharge treatment of the polyimide can be advantageously done utilizing an electric power in the range of about 125 to 215 W-min/m$^2$ in ambient air.

The criticality of the invention process resides in a further electric discharge treatment of a fluorocarbon polymer film layer in an atmosphere containing acetone vapor substantially as disclosed in U.S. 3,627,624 which is incorporated herein by reference. More specifically, the surface of the fluorocarbon polymer film is subjected to an electric discharge at an average power level ranging from 50 to 160 W-min/m$^2$ using treating speeds from 40 to 50 fpm at atmospheric pressure, and in an atmosphere containing from 1 to 5% by volume of acetone vapor in a gaseous carrier medium which will sustain the electric discharge. It has been unexpectedly found that the heat seal strength of the laminate of the polyimide film and the fluorocarbon polymer film is highly dependent on the treating atmosphere used for the fluoropolymer film. Treatment of the fluorocarbon polymer film in air results in little bonding, whereas treatment in an acetonenitrogen atmosphere provides a 10 to 30 times increase in bond values. On the other hand, the atmosphere for electrical discharge treatment of the polyimide film has little effect on the bond values of the final laminar structure.

In general the treated polyimide and the treated fluoropolymer films are united to form a laminar structure by heat sealing the treated sides together under pressure. In the examples given below the industry standard sealing temperature of 350°C and a slightly lower temperature of 315°C, are used to produce the seals. Two film lay-ups are used to produce the laminate structures. The film lay-ups are held at the above temperatures at 20 psi for 15-20 seconds.

The data in Tables I to VI show the lack of effect of polyimide treatment atmosphere and the effect of fluoropolymer treatment atmosphere on the laminate bonding.

In the present invention, the fluoropolymer film can be provided on a single surface of the polyimide film or, preferably, on both surfaces of the polyimide film so that the composite laminar structure can be used as a covering material for insulation of electric wire.

Laminar structures prepared by the process of the present invention are useful in applications where a heat-sealable film, stable at high temperatures, is desirable. The laminar structures are especially useful in electrical applications where heat-sealability is desired such as in insulation for various types of wire, cable, strap insulation for motors or motor armatures, motor slot liners, insulation for motor protectors and fuses, and as capacitor dielectric and backing for printed circuits.

The present invention is further described but not limited by the following examples. All percentages are by weight unless otherwise indicated.

EXAMPLES

A. Effect of Fluoropolymer Treatment Atmosphere on Adhesion to Polyimide

A 0.5 mil tetrafluoroethylene-hexafluoropropylene copolymer (FEP) film was corona discharge treated on both sides in air. The power level was 86 to 54 W-min/m$^2$ at treating speeds of 50 and 80 fpm. A considerable amount of pucker was evident.

The treater was then set for treatment in acetone/ nitrogen atmosphere. The treatment conditions were the same as above with the atmosphere in the treater measuring 3.1-3.2 volume % acetone. The amount of pucker was considerably reduced over that previously observed.

Samples of the 0.5 FEP film treated under the four conditions (air and acetone/nitrogen treated at both 50 fpm and 80 fpm) were heat-sealed to (1-mil) untreated polyimide base film and corona treated polyimide base film. The polyimide film was derived from pyromellitic acid dianhydride and 4,4'-diaminodiphenyl ether.

The heat seals were constructed by placing a sheet of the treated FEP film between two sheets of the polyimide film as shown in the Figure. For samples A, B, C and D the FEP film was folded in half prior to placement between the two sheets of the polyimide film (so that a 4-ply construction of 3 mils was present). For samples E, F, G and H only a single film of FEP was employed (so that a 3-ply construction of 2.5 mils was present). Each construction (1 inch wide x 4 inches long) was placed in a jaw heat sealer and a 1 inch x 1 inch section sealed together. The loose, unbonded polyimide tabs were placed in an Instron peel tester and the seal pulled apart.

Four heat seal values were obtained for each construction for the four FEP film treatment conditions. The results are given in Table I for 315°C heat-seals and in Table II for 350°C heat-seals. The seal values of the FEP film treated in acetone/nitrogen and untreated polyimide base film are given in Table III. No heat-seals were made with FEP film treated in air and untreated polyimide film because of the initial low values observed in Tables I and II.

The results in Tables I, II and III indicate little effect of seal construction on bond strength. A summary of the average heat-seal values at 315°C and 350°C is given in Table IV and clearly shows that the adhesion improving effectiveness of corona treatment of FEP film is very dependent on the atmosphere.

## Table I

### 315°C Heat Seals, g/in
### FEP Film with Corona Treated Polyimide Film

| FEP Treatment Conditions | Seal Construction | | | |
|---|---|---|---|---|
| | A | B | C | D |
| Air, 50 fpm | 35 | 31 | 34 | 35 |
| | 34 | 33 | 34 | 34 |
| | 34 | 37 | 33 | 38 |
| | 33 | 33 | 33 | 34 |
| | -- | -- | -- | -- |
| | 34 | 33 | 33 | 35 |
| Air, 80 fpm | 40 | 39 | 44 | 44 |
| | 40 | 44 | 41 | 40 |
| | 37 | 45 | 44 | 43 |
| | 37 | 40 | 41 | 40 |
| | -- | -- | -- | -- |
| | 39 | 43 | 43 | 42 |
| Acetone, 50 fpm | 554 | 628 | 523 | 476 |
| | 532 | 536 | 476 | 475 |
| | 551 | 570 | 498 | 500 |
| | 547 | 550 | 474 | 502 |
| | --- | --- | --- | --- |
| | 546 | 571 | 493 | 488 |
| Acetone, 80 fpm | 1129 | 389 | 425 | 340 |
| | 431 | 383 | 1209 | 335 |
| | 421 | 369 | 367 | 389 |
| | 426 | 394 | 475 | 422 |
| | ---- | --- | ---- | --- |
| | 602 | 384 | 619 | 372 |

## Table II

### 350°C Heat Seals, g/in
### FEP Film with Corona Treated Polyimide Film

| FEP Treatment Conditions | Seal Construction | | | |
|---|---|---|---|---|
| | E | F | G | H |
| Air, 50 fpm | 38 | 38 | 38 | 40 |
| | 37 | 39 | 59 | 36 |
| | 33 | 39 | 35 | 38 |
| | 35 | 36 | 37 | 43 |
| | -- | -- | -- | -- |
| | 36 | 38 | 42 | 39 |
| Air, 80 fpm | 34 | 31 | 45 | 34 |
| | 33 | 37 | 37 | 40 |
| | 33 | 39 | 34 | 31 |
| | 31 | 33 | 33 | 39 |
| | -- | -- | -- | -- |
| | 33 | 35 | 37 | 36 |
| Acetone, 50 fpm | 1178 | 968 | 1008 | 1049 |
| | 1306 | 1026 | 1233 | 935 |
| | 1074 | 1118 | 851 | 1108 |
| | 1042 | 1148 | 698 | 1025 |
| | ---- | ---- | ---- | ---- |
| | 1150 | 1065 | 947 | 1029 |
| Acetone, 80 fpm | 648 | 590 | 799 | 1040 |
| | 799 | 531 | 527 | 751 |
| | 847 | 826 | 504 | 789 |
| | 616 | 626 | 668 | 1007 |
| | --- | --- | --- | ---- |
| | 727 | 643 | 624 | 897 |

## Table III

### 315°C Heat Seals, g/in

### FEP Film with Untreated Base Polyimide Film

| FEP Treatment Conditions | Seal Construction | | | |
|---|---|---|---|---|
| | A | B | C | D |
| Acetone, 50 fpm | 301 | 247 | 287 | 198 |
| | 266 | 255 | 261 | 255 |
| | 249 | 323 | 256 | 301 |
| | 298 | 304 | 288 | 297 |
| | 288 | 274 | 301 | 305 |
| | --- | --- | --- | --- |
| | 281 | 280 | 279 | 271 |
| Acetone, 80 fpm | 71 | 97 | 237 | 92 |
| | 58 | 53 | 165 | 62 |
| | 77 | 122 | 178 | 143 |
| | 100 | 136 | 181 | 128 |
| | 110 | 118 | 268 | 107 |
| | --- | --- | --- | --- |
| | 83 | 105 | 206 | 106 |

350°C Heat Seals, g/in
__FEP Film with Untreated Base Polyimide Film__

| FEP Treatment Conditions | Seal Construction | | | |
|---|---|---|---|---|
| | __E__ | __F__ | __G__ | __H__ |
| Acetone, 50 fpm | 594 | 552 | 750 | 634 |
| | 663 | 662 | 627 | 616 |
| | 519 | 646 | 636 | 585 |
| | 649 | 721 | 715 | 451 |
| | 659 | 839 | 695 | 540 |
| | --- | --- | --- | --- |
| | 617 | 684 | 684 | 566 |
| Acetone, 80 fpm | 429 | 386 | 385 | 224 |
| | 381 | 313 | 339 | 154 |
| | 291 | 366 | 362 | 341 |
| | 249 | 323 | 454 | 278 |
| | 296 | 482 | 516 | 374 |
| | --- | --- | --- | --- |
| | 329 | 374 | 411 | 274 |

## Table IV

### Summary of Average 315°C and 350°C
### Heat Seal Values, g/in
### FEP Film with Treated and Untreated Polyimide Film

#### 315°C Heat Seals, g/in

| FEP Treatment Condition | Treated Polyimide | Untreated Polyimide |
|---|---|---|
| Air, 50 fpm | 34 | -- |
| Air, 80 fpm | 41 | -- |
| Acetone, 50 fpm | 524 | 278 |
| Acetone, 80 fpm | 494 | 125 |

#### 350°C Heat Seals, g/in

| | Treated Polyimide | Untreated Polyimide |
|---|---|---|
| Air, 50 fpm | 39 | -- |
| Air, 80 fpm | 35 | -- |
| Acetone, 50 fpm | 1048 | 638 |
| Acetone, 80 fpm | 723 | 347 |

B. Effect of Polyimide Treatment Atmosphere on Adhesion to Acetone Treated Fluoropolymer

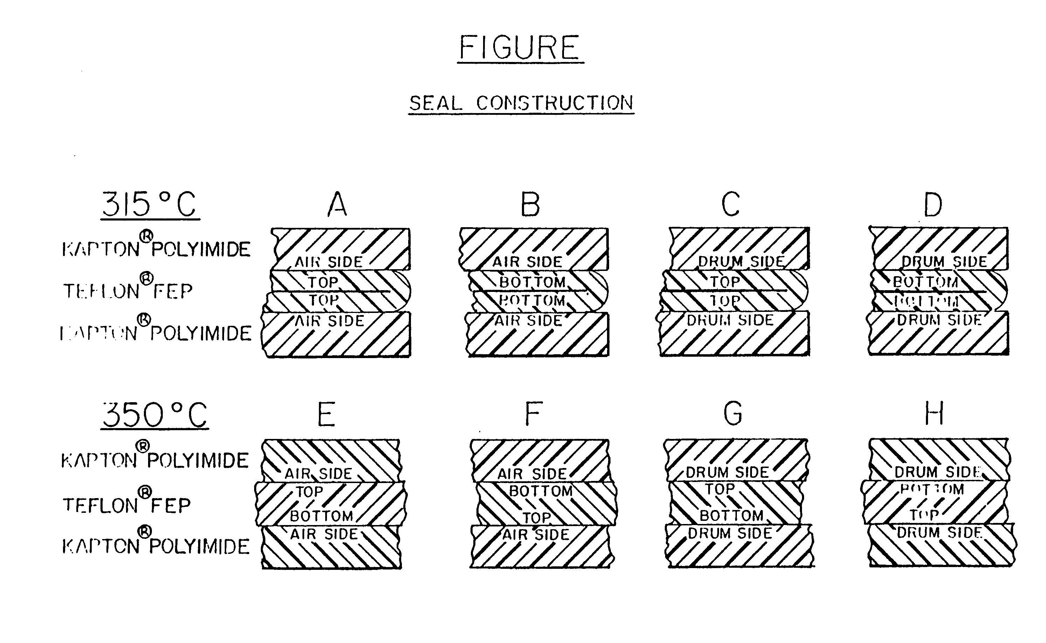

The polyimide (1-mil) derived from pyromellitic dianhydride and 4,4'-diaminodiphenyl ether was electrical discharge treated in air, nitrogen and acetone atmospheres at power levels of 215 W-min/m$^2$ and 430 W-min/m$^2$. The treated 1-mil polyimide films were bonded to an acetone treated 0.5-mil FEP film. The seal construction is indicated in Figure 1. The sealing was done as described above. The data in Tables V and VI show similar adhesion levels are obtained with the corona treated polyimides, i.e. all treatment atmospheres appear equally effective. The values are greater than those obtained with the base, untreated polyimide.

## Table V

### 315°C Heat Seals, g/in
### Corona Treated Polyimide Film
### with Acetone Treated FEP film

| Polyimide Treatment Conditions | Seal Contruction | |
|---|---|---|
| | A | C |
| Air, 40 fpm | 820 | 723 |
| Air, 20 fpm | 1033 | 705 |
| Nitrogen, 40 fpm | 940 | 710 |
| Nitrogen, 20 fpm | 917 | 832 |
| Acetone, 40 fpm | 1085 | 817 |
| Acetone, 20 fpm | 1142 | 965 |
| Untreated | 536 | 505 |

## Table VI

### 350°C Heat Seals, g/in
### Corona Treated Polyimide Film
### with Acetone Treated FEP Film

| Polyimide Treatment Conditions | Seal Contruction | |
|---|---|---|
| | E | G |
| Air, 40 fpm | 1484 | 831 |
| Air, 20 fpm | 1592 | 1003 |
| Nitrogen, 40 fpm | 1267 | 759 |
| Nitrogen, 20 fpm | 1558 | 853 |
| Acetone, 40 fpm | 1157 | 803 |
| Acetone, 20 fpm | 1129 | 750 |
| Untreated | 849 | 674 |

**Claims**

1. A process for preparing a laminar structure of at least one layer of a polyimide film and at least one layer of a fluorocarbon polymer film comprising the steps of
   (a) subjecting a polyimide film surface to an electric discharge treatment,
   (b) subjecting a fluorocarbon polymer film surface to an electric discharge treatment in an acetone atmosphere,
   (c) laminating the polyimide film surface and the fluorocarbon polymer film surface to form an adherent laminate.

2. The process of claim 1 wherein the polyimide is derived from the polymerization and imidization of pyromellitic dianhydride and 4,4'-diaminodiphenylether.

11

3. The process of claim 1 wherein the fluorocarbon polymer is a copolymer of from 50 to 95% by weight tetrafluoroethylene and from 5 to 50% by weight hexafluoropropylene.

4. The process of claim 1 wherein said fluorocarbon polymer film surface is rendered adherable by subjecting said surface to an electric discharge treatment in an atmosphere containing from 1 to 5 volume % acetone.

5. The process of claim 1 wherein said adherable polyimide film surface is laminated to said adherable fluorocarbon polymer film surface using a temperature from 315 to 350°C and a pressure of about 20 psi for 15-20 seconds.

# FIGURE

## SEAL CONSTRUCTION

**315°C**

KAPTON® POLYIMIDE

TEFLON® FEP

KAPTON® POLYIMIDE

| A | B | C | D |
|---|---|---|---|
| AIR SIDE | AIR SIDE | DRUM SIDE | DRUM SIDE |
| TOP | BOTTOM | TOP | BOTTOM |
| TOP | BOTTOM | TOP | BOTTOM |
| AIR SIDE | AIR SIDE | DRUM SIDE | DRUM SIDE |

**350°C**

KAPTON® POLYIMIDE

TEFLON® FEP

KAPTON® POLYIMIDE

| E | F | G | H |
|---|---|---|---|
| AIR SIDE | AIR SIDE | DRUM SIDE | DRUM SIDE |
| TOP | BOTTOM | TOP | BOTTOM |
| BOTTOM | TOP | BOTTOM | TOP |
| AIR SIDE | AIR SIDE | DRUM SIDE | DRUM SIDE |

EP 0 467 096 A1

European Patent Office

**EUROPEAN SEARCH REPORT**

Application Number

## DOCUMENTS CONSIDERED TO BE RELEVANT

EP 91110301.8

| Category | Citation of document with indication, where appropriate, of relevant passages | Relevant to claim | CLASSIFICATION OF THE APPLICATION (Int. Cl.5) |
|---|---|---|---|
| D | US - A - 4 801 506 (MOTONARI) | | B 29 C 71/04 |
| | | | B 29 C 59/10 |
| | | | B 29 D 9/00 |
| Y | * Column 2, lines 29-64 * | 1 | B 32 B 27/16 |
| X | * Column 7, lines 12-15 * | 5 | B 32 B 27/32// |
| A | * Column 4, lines 26,27 * | 3 | //B 29 K 79:00 |
| | -- | | B 29 K 27:18 |
| D | US - A - 3 627 624 (KREUZ) | | B 29 L 9:00 |
| Y | * Column 7, lines 34-42 * | 1 | |
| X | * Column 1, lines 57-63; | 3 | |
| | - . .column 6, lines 63-75 * | | |
| | * Column 7, line 40 * | 4 | |
| | -- | | |
| D | US - A - 3 179 614 (EDWARDS) | | |
| X | * Column 14; example 26 - column 15, line 16 * | 2 | |
| A | * Column 17; examples 41-44 * | 3 | TECHNICAL FIELDS SEARCHED (Int. Cl.5) |
| | -- | | |
| D | US - A - 3 179 630 (ENDREY) | | B 29 C |
| | | | B 29 D |
| A | * Examples 18,29-36,38-45 * | 2 | B 32 B |
| | * Column 4, lines 39,40 * | 3 | C 08 G |
| | -- | | C 08 L |
| D,A | US - A - 3 179 634 (EDWARDS) * Totality * | 1-3 | |
| | -- | | |
| A | EP - A1 - 0 246 681 (SOLVAY) * Totality * | | |
| | -- | | |
| A | US - A - 3 575 793 (PAISLEY) * Totality * | | |
| | ---- | | |

The present search report has been drawn up for all claims

| Place of search | Date of completion of the search | Examiner |
|---|---|---|
| VIENNA | 31-10-1991 | MAYER |